# EUROPEAN PATENT APPLICATION

(11) **EP 4 429 419 A1**
(43) Date of publication of application: **11.09.2024**
(21) Application number: 24161956.8
(22) Date of filing: 07.03.2024
(51) Int. Cl.: H05K 5/00

(54) **HOUSING FOR A PRINTED CIRCUIT BOARD (PCB) AND PCB ASSEMBLY**

(30) Priority: 09.03.2023 IT 202300004455
(71) Applicant: TE Connectivity Italia Distribution S.r.l., 10093 Collegno (TO) (IT)
(72) Inventor: GENTA, Alessandro, 10093 Collegno (IT)
(74) Representative: Grünecker Patent- und Rechtsanwälte PartG mbB

(57) **Abstract**

The present invention refers to a housing for a PCB comprising a PCB board and a plurality of connecting areas provided with header pins groups. The housing comprises a main body and a plurality of header holes delimited by header walls and configured to accommodate the corresponding header pins groups. The housing further comprises adaptation means associated with each of the header holes, wherein the adaptation means allow the movement of each header wall with respect to the plurality of header holes in a first and/or in a second direction of a plane of the main body of the housing, so as to align the header walls with the header pins groups. The present invention also refers to a PCB assembly comprising the housing and the PCB and to a method of assembling same.

## Description

The present invention refers to the technical field of electrical connectors. In particular, the present invention refers to a housing for a Printed Circuit Board (PCB) and to a PCB assembly comprising the housing and a PCB.

### State of the art

Large PCBs (i.e. PCBs with dimensions of approximately 375 mm x 145 mm) are commonly used in the automotive industry for providing a high number of electrical contacts for performing different functions. For example, large PCBs can be used in control units for vehicles.

In the state of the art related to press-fit or other similar technologies, the pin contact is directly mounted onto the PCB, while the rest of the connections, e.g. contact cavities, guiding element for plug housing, are provided on additional covers or housings.

When large PCBs with a high number of contacts are coupled with corresponding housings, a correct coupling, along a coupling plane perpendicular to the insertion direction, between the two components may be hindered by a misalignment between one or more electrical contacts of the PCB and the corresponding housing holes. This misalignment is mainly due to tolerance issues arising during the design of the PCB and/or the housing. If the two components are not correctly aligned there is a risk to accidentally bend the contact pins during the coupling. Typically, it is necessary to overcome a misalignment gap of 0.75 mm or more. However, in some cases, the misalignment gap may be of 2 mm.

In view of the above problems, there is a need for a connection system that automatically compensates for a misalignment between the PCB and the corresponding housing on a coupling plane perpendicular to the insertion direction.

The present invention provides a housing and a PCB assembly that overcome these problems.

### Summary

The present invention is based on the idea of providing a housing for a PCB having adaptation means that ensure an automatic alignment between the housing and the corresponding PCB. According to an aspect of the present invention, a housing suitable for housing a PCB is provided, the PCB defining a PCB plane (XY) and comprising a plurality of connecting areas provided with header pins groups; the housing comprising a main body defining a housing plane (X'Y'), wherein the housing plane (X'Y') is parallel to the PCB plane (XY) when the PCB is housed in the housing, the housing further comprising a plurality of header holes delimited by header walls and configured to accommodate the corresponding header pins groups. According to the present invention the housing further comprises adaptation means associated with each of the header holes, wherein the adaptation means allow the movement of each of the plurality of header walls with respect to the plurality of header holes in a first (X') and/or in a second (Y') direction on the housing plane (X'Y'), so as to align the header walls with the header pins groups.

The advantage of the present invention is to allow an easy and precise insertion of the PCB comprising more connecting areas with pins into the corresponding housing, avoiding the pins of the header pins groups to accidentally bend during the process. Since this alignment is carried out in an automatic way, the solution according to the present invention allows to simultaneously align a large number of connecting areas, with the corresponding header holes.

According to a preferred embodiment, the adaptation means may include elastic means that allow a movement of the housing walls along the coupling plane perpendicular to the insertion direction. According to an alternative embodiment, the adaptation means may include retainer elements that allow a movement of the housing walls along the coupling plane perpendicular to the insertion direction.

The present invention further concerns a PCB assembly, comprising a housing according to any embodiment of the present invention and a PCB housed in the housing.

According to a preferred embodiment, the housing can comprise one or more guiding pins associated with each header hole and the PCB can comprise one or more corresponding guiding holes; wherein each of the one or more guiding pins is configured to be inserted into each of the corresponding guiding holes, so as to facilitate the insertion of each header pins group into the corresponding header holes. In this way, the guiding pins advantageously induce and ensure a preliminary right alignment between the connecting areas and the corresponding header holes.

The present invention further concerns a method for assembling a PCB assembly comprising the following steps: providing a housing according to the present invention and providing a PCB comprising a plurality of connecting areas provided with header pins groups; coupling the housing to the PCB, whereby the adaptation means move one or more of the plurality of header walls with respect to the plurality of header holes in the first and/or the second direction, so as to align the one or more header walls with the corresponding header pins group.

According to a preferred embodiment, the housing comprises one or more guiding pins and the PCB comprises one or more corresponding guiding holes. In this case, the method further comprises the following step: inserting one or more guiding pins into the corresponding guiding hole. In this way, the guiding pins advantageously induce and ensure a preliminary right alignment between the connecting areas and the corresponding header holes.

The present invention further concerns the use of a PCB assembly or of a connector, according to the present invention, as a connector in a vehicle, for example a truck. The connector can be, for example, a control unit for the vehicle, for example the main or single control unit of the vehicle.

### Brief description of the drawings

The present invention will be described with reference to the attached figures in which the same reference numerals and/or signs indicate the same part and/or similar and/or corresponding parts of the machine.
Fig. 1 schematically shows an exploded view of a a connector according to an embodiment of the present invention;
Fig. 2 shows the connector of Fig. 1 in the assembled state. The assembled connector of Fig. 2 is rotated by 180° with respect to the Y-axis when compared to the connector of Fig. 1;
Fig. 3 shows a contact area of the PCB with a header pins group.
Fig. 4a shows a top view of a PCB assembly, according to an embodiment of the present invention;
Fig. 4b shows a zoomed-in particular of Fig. 4a;
Fig. 5 shows a connector in the assembled state, according to an embodiment of the present invention.
Fig. 6 shows a top view of the housing, according to another embodiment of the present invention;
Fig. 7a shows a zoomed-in view of a header hole according to another embodiment of the present invention;
Fig. 7b shows the header hole of Fig. 7a, along the AA and BB directions, indicated in Fig. 7a;
Fig. 8 shows a connector according to another embodiment of the present invention.

### Detailed description

In the following, the present invention is described with reference to particular embodiments as shown in the enclosed drawings. Nevertheless, the present invention is not limited to the particular embodiments described in the following detailed description and shown in the figures, but, instead, the embodiments described simply exemplify several aspects of the present invention, the scope of which is defined by the appended claims.

Further modifications and variations of the present invention will be clear for the person skilled in the art. Therefore, the present description has to be considered as including all the modifications and/or variations of the present invention, the scope of which is defined by the appended claims.

For simplicity, identical or corresponding components are indicated in the figures with the same reference numbers.

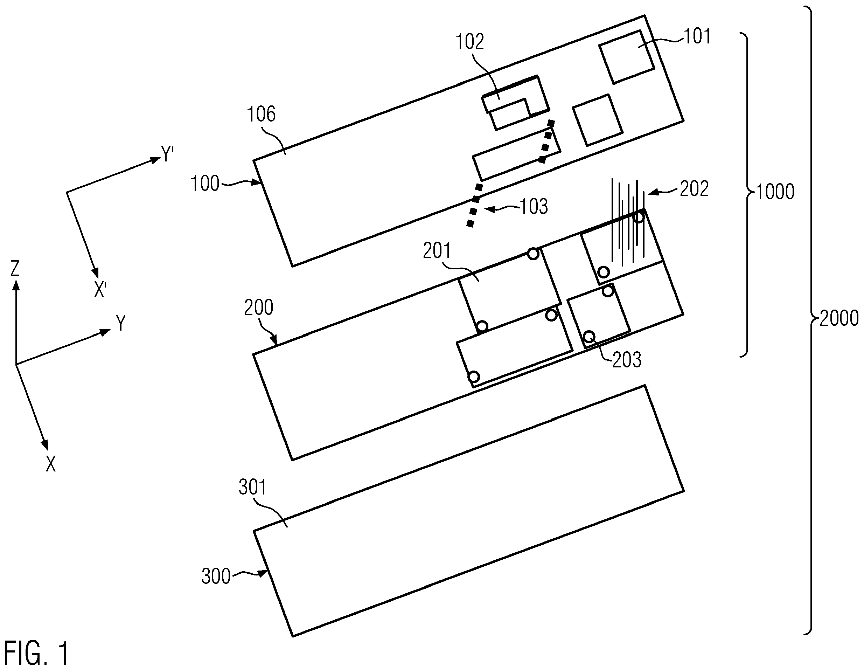

Fig. 1 schematically shows an exploded view of a connector 2000 according to the present invention. The connector 2000 is suitable to be used, for example, as a one-piece electrical control unit in a vehicle, such as a transport truck.

The connector 2000 comprises a housing 100, a PCB 200 and a cover 300.

The PCB 200 shown in Fig. 1 defines a PCB plane XY. The shown PCB has a rectangular shape, but any other suitable planar shape falls within the scope of the present invention.

Referring to the PCB plane XY, a Cartesian reference system XYZ can be defined. In the following, reference is made to this reference system XYZ. In particular, the XY plane of the reference system XYZ is defined as the PCB plane XY, wherein the X axis is parallel to the short side of the PCB 200 shown in Fig. 1 and the Y axis is parallel to the long side of the PCB 200 and the Z axis is in the direction perpendicular to the PCB plane XY.

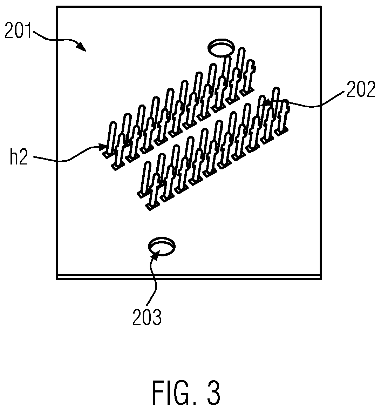

The PCB 200 comprises a plurality of connecting areas 201. Each connecting area 201, better shown in Fig. 3, is provided with a header pins group 202 and can comprise one or more guiding holes 203. The typical dimensions for a connecting area 201 are 90 mm x 40 mm. However each connecting area 201 can have different dimensions, according to the needed number of pins in it.

A header pins group 202 is a group of metallic pins, preferably press-fit inserted onto the corresponding connecting area 201 of the PCB 200, which guarantee the electrical connection to the corresponding cables, once the connector 2000 is in use. Each guiding pin has a length h2, defined along the Z direction. Preferably, all the pins of a header pins group 202 have the same length h2. More preferably, all the pins of all the header pins groups 202 have the same length h2. A typical length h2 for the pins is of the order of 10 mm. However, the length h2 can vary according to the needs.

The guiding holes 203 are holes formed on the connecting area 201 suitable to facilitate the proper insertion of each header pins group 202 into the corresponding header hole 101 of the housing 100, as detailed in the following.

The housing 100 comprises a main body 106 defining a housing plane X'Y', wherein the housing plane X'Y' is parallel to the PCB plane XY when the PCB 200 is housed in the housing 100, as shown, for example, in Fig. 1. The housing 100 comprises a lower surface 105 facing the PCB 200 and an upper surface 104 facing the outside of the connector 2000. The housing 100 shown in Fig. 1 has a rectangular shape with a short side, having a length of 145 mm and a long side, having a length of 375 mm. The shape of the housing 100 is not limited to a rectangular shape, but it can be any shape compatible with the shape of the PCB 200. In a similar way, the size of the housing 100 is not limited to the indicated values, but it can have any size compatible with the size of the PCB 200.

The housing 100 comprises a plurality of header holes 101. Each header hole 101 corresponds to a connecting area 201 on the PCB 200. More in particular, each header hole 101 on the housing 100 is configured to accommodate a corresponding header pins group 202. The typical dimensions for a connecting hole 101 are 90 mm x 40 mm. However, each connecting hole 101 can have different dimensions, according to the dimensions of the corresponding connecting area 201. Each header hole 101 is delimited by header walls 102. The header walls 102 are arranged inside the corresponding header holes 101 and can form a continuous wall.

In the embodiment shown in Fig. 1, the header walls 102 protrude from the housing plane X'Y' 100 inward, i.e., toward the PCB 200, parallel to the Z direction. The length h1 (not indicated in the figures) of each of the header walls 102 along the Z direction is preferably larger than the length h2 of the pins of the corresponding header pins group 202. In this way, once the connector 2000 is mounted, the pins of each header pins group 202 do not protrude beyond the housing plane X'Y'. A typical length h1 for the header walls 102 is in the range from 40 mm to 50 mm. However, the length h1 can vary according to the needs.

The header walls 102 can be made of any suitable insulating material, for example a plastic material.

Considering that the PCB 200, according to the present invention, comprises a plurality of connecting areas 201, it would be difficult to insert all the header pins groups 202 correctly into the corresponding header holes 101 simultaneously, if the header walls 102 were fixed onto the housing 100. In fact, tolerance studies, performed by the inventors on similar components, show that there is a gap that has be taken into account when mounting a PCB comprising a plurality of connecting areas into a corresponding housing. A mobility of the header walls 102 is hence necessary to compensate for this gap. This is required to avoid the bending of the pins of the header pins groups 202 during the insertion step into the corresponding header holes 101. The tolerance studies showed that this gap is of the order of 1 mm, with an average value of 0.75 mm and a maximum value of 2 mm.

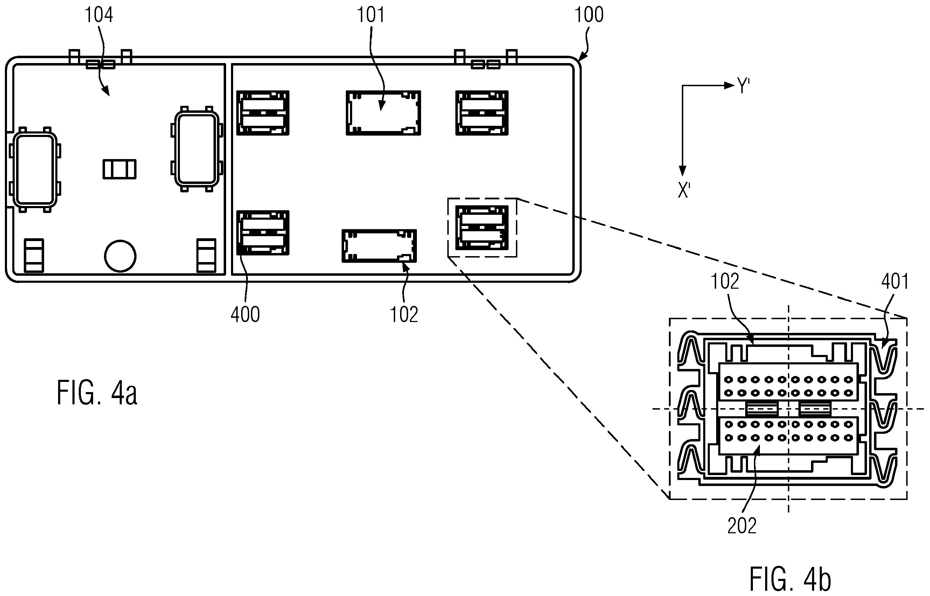

For this reason the housing 100 further comprises adaptation means 400, 500, which are described in detail with reference to Fig. 4a, 4b, 6, 7a and 7b below, associated with each of the header holes 101. The adaptation means 400, 500 allow the movement of each of the header walls 102 with respect to the corresponding header hole 101 in a first direction X' and/or in a second direction Y` on the housing plane X'Y'. Therefore, the header walls 102 can independently move in the X' direction and in the Y' direction over a range of the order of about 1 mm, and consequently, on the housing plane X'Y'. This results in the possibility of simultaneously aligning all the header walls 102 with the corresponding header pins groups 202, so as to ensure a correct insertion of the latter in the former and to avoid any deformation of the pins of the header pin groups 202.

The housing 100 can further comprise one or more guiding pins 103 associated with each header hole 101. Each guiding pin 103 is configured to be inserted into a corresponding guiding hole 203 of the connecting area 201 of the PCB 200, so as to facilitate the insertion of each header pins group 202 into the corresponding header holes 101. In particular, when each guiding pin 103 is inserted into the corresponding guiding hole 203, the alignment of the header walls 102 with the corresponding header pins group 202 is induced and ensured.

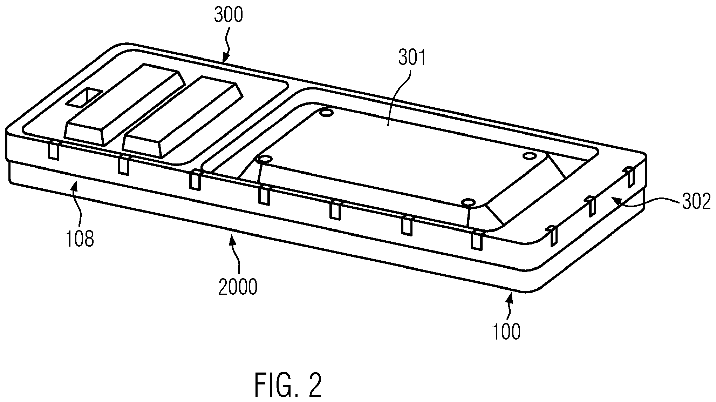

The housing 100 also comprises lateral walls 108, shown in Fig. 2, extending along the perimeter of the main body 106 of the housing 100, toward the PCB 200 in the Z direction, and comprising first coupling means, for example clips (not shown in the figures), suitable to allow a correct coupling of the housing 100 to the cover 300.

The housing 100 can be made of any suitable durable and insulating material, for example a plastic material.

The cover 300 comprises a main body 301 and lateral walls 302, shown in Fig. 2, extending along the perimeter of the main body 301 of the cover 300, toward the PCB 200, in the Z direction, and comprising second coupling means, for example clips (not shown in the figures), suitable to allow a correct coupling of the cover 300 to the housing 100.

The shape of cover 300 is not limited to a rectangular shape, as shown in Fig. 1 or 2, but it can be any shape compatible with the shape of the housing 100.

The cover 300 has the function of protecting the rear face (not visible in the figures) of the PCB 200 and is mounted so as to accommodate said PCB 200 between said housing 100 and said cover 300. It can be made of any suitable durable and insulating material, for example a plastic material.

Fig. 2 shows the connector shown in Fig. 1 in the assembled state. The assembled connector is shown rotated by 180° with respect to the Y axis when compared to the configuration of Fig. 1, thus allowing to better see the cover 300. The assembled connector of Fig. 2 is ready to be used as a control unit, for instance in a vehicle such as a truck.

Fig. 3 shows a contact area 101 of the PCB 200. The contact area 100 is provided with a header pins group 202 and it comprises one or more guiding holes 203. The header pins group 202, shown in the figure, comprises two sets of parallel pins and a pair of guiding holes 203. However, this is not limiting for the present invention and the header pins group 202 may comprise, for instance, one, three, four or more sets of parallel pins and/or one, three, four or more guiding holes 203.

Fig. 4a shows a top view of a PCB assembly 1000, according to a first embodiment of the present invention.

The PCB assembly 1000 comprises a housing 100 and a PCB 200.

In particular, Fig. 4a shows the upper face 104 of the housing 100 according to a first embodiment of the present invention, in which the PCB 200 is mounted. In Fig. 4, the header pins group 202 are inserted into the corresponding header holes 101 delimited by the header walls 102.

Fig. 4a also shows the adaptation means 400, according to a first embodiment of the present invention. The adaption means 400 are associated with each corresponding header hole 101, in particular they are mounted between each header hole 101 and the corresponding header walls 102. According to a first embodiment of the invention, the adaption means 400 comprise elastic springs 401, better shown in Fig. 4b. In particular, the elastic springs 401 are inserted between each header hole 101 and each corresponding header wall 102. More in particular, the elastic springs 401 can, for example, be fitted into corresponding mounting holes (not shown in the fig-ures) in the header holes 101 and the header walls 102. The elastic springs allow the header walls 102 to move independently along the X' and the Y' directions inside the header hole 101, along the housing plane X'Y'. The range of movement of the header walls into the X' and/or the Y' direction is respectively of the order of 1 mm, for instance between 0.75 mm and 2 mm.

Fig. 4b shows a zoomed view of a particular of Fig. 4a. In particular, it shows a zoomed-in view of a header hole 101 delimited by header walls 202 and associated with the adaptation means 400 and in which a connecting area 201 of a PCB 200 is inserted. Two sets of three elastic springs 401 are mounted between the header hole 101 and the header wall 102, in the drawing shown in Fig. 4a, but the number and the positioning of the elastic springs 401 can vary according to the needs.

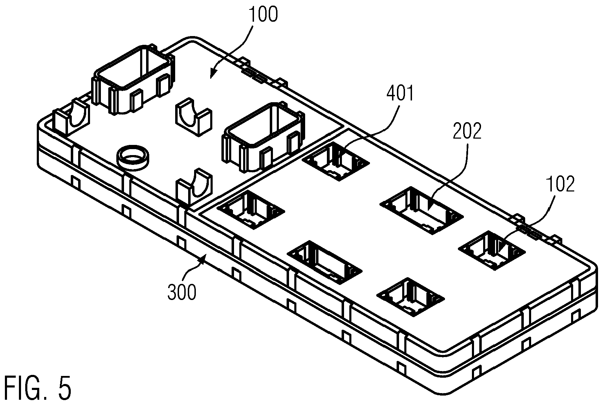

Fig. 5 shows a top view of the connector according to a first embodiment of the present invention. The connector is shown with the housing 100 on top and it is assembled, i.e. the cover 300 is mounted. The figure further shows the header pins groups 202 surrounded by the header walls 102. The embodiment shown uses the elastic springs 401, as adaptation means 400.

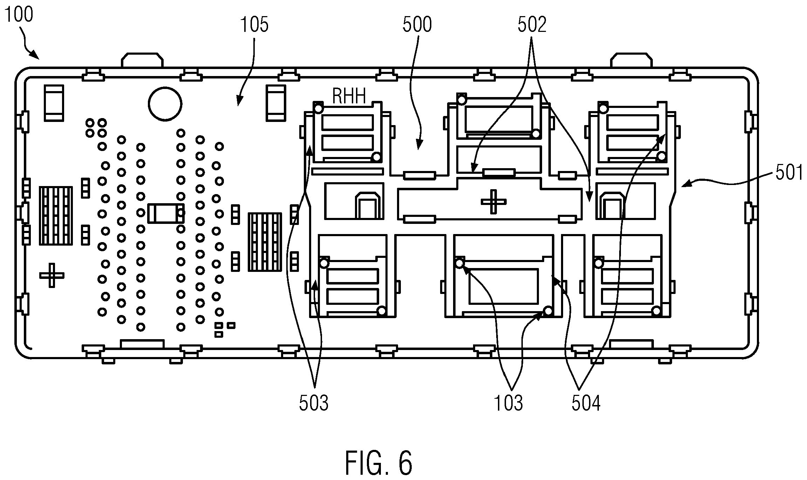

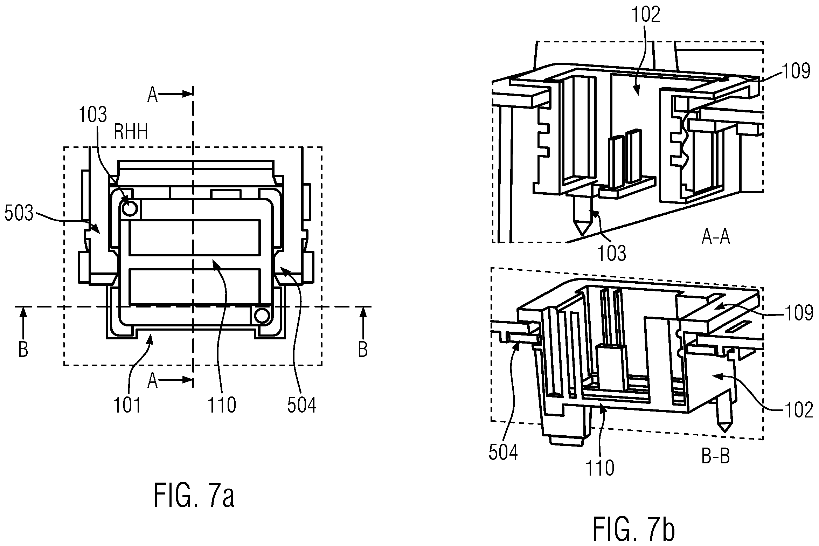

Fig. 6 shows a top view of the housing 100, according to a second embodiment of the present invention. In this case, the lower face 105 of the housing 100 is showed and the figure shows adaptation means 500 according to a second embodiment of the present invention. The adaptation means 500 comprise a retainer 501, comprising a bridge structure 502 and wrap-around arms 503. Each of the wrap-around arms 503 surrounds completely or partially a corresponding header hole 101 of the housing 100 and all the wrap-around arms 503 are steady held together by the bridge structure 502. Moreover, every wrap-around arm 503 comprises one or more protruding hooks 504 (see also Fig. 7a). As shown in Figs. 7a and 7b, according to this embodiment, the header walls 102 further comprise a protruding rim 109, protruding onto the main body 106 of the housing 100, and a floor with openings 110. The protruding rim 109 and the floor with openings 110 are both parallel to the main body 106 and perpendicular to the header walls 102. Each wrap-around arm 503 is slightly larger than the corresponding header wall 102, therefore, by exploiting the protruding rim 109 (better visible in Fig. 7b), each of the header walls 102 can be positioned into the corresponding header hole 101, so as to be movable on the housing plane X'Y' inside the corresponding header hole 101. The protruding hooks 504, by engaging corresponding protrusions (not shown in the figures) of the header walls 102, prevent the movement of the header walls 102 along the Z' direction and limit the movement of each header wall 102 into the corresponding header hole 101, ensuring that the possible movement is of the order of 1 mm, both in the X' direction and in the Y' direction on the housing plane X'Y'. The retainer 501 and the protruding rim 109 can be made of any suitable insulating material, for example a plastic material.

Fig. 7a shows a zoomed-in view of a header hole 101 according to the second embodiment of the present invention. The shown header hole 101 is the one on the top left of Fig. 6, indicated with the letters RHH (Reference Header Hole), rotated by 180° with respect to the Z axis. The figure shows the wrap-around arms 503 and the protruding hooks 504. In this case, the wrap-around arms 503 surround the header hole 101 only on three sides and there are two protruding hooks 504. Moreover, the figure shows the floor with openings 110 of the header walls 102. The floor with openings 110 is open to allow the insertion of the header pin groups 202 into the header walls 102.

Fig. 7b shows the header hole of Fig. 7a, along the AA and BB directions, indicated in Fig. 7a. In particular, the figure shows the header walls 102, comprising the protruding rims 109, the floor with openings 110 and the protruding hooks 504.

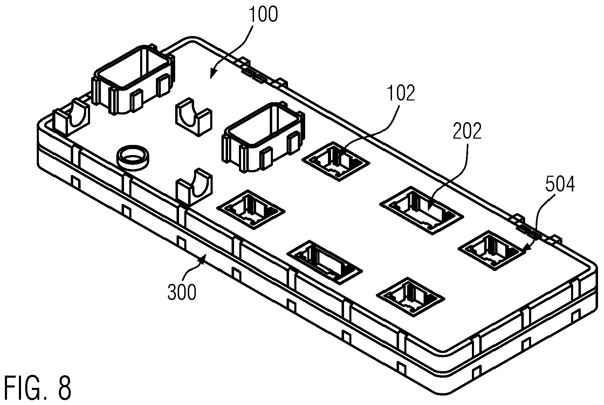

Fig. 8 shows a connector according to the second embodiment of the present invention. The connector is shown with the housing 100 on top and it is assembled, i.e. the cover 300 is mounted. The figure further shows the header pins groups 202 surrounded by the header walls 102, comprising the protruding rims 505. The embodiment shown uses the retainer 501, as adaptation means 500.

In the following, the method for assembling the PCB assembly according to the first/second embodiment is disclosed. The method comprises the following steps: providing a housing 100 according to the present invention; providing a PCB 200 comprising a plurality of connecting areas 201 provided with header pins groups 202; coupling the housing 100 to the PCB 200, so that the adaptation means 400, 500 move one or more of the plurality of header walls 102 with respect to the plurality of header holes 101 in a first X' and/or a second Y' direction defining a housing plane X'Y' and align them with the header pins groups 202. If the housing 100 comprises one or more guiding pins 103 and the PCB 200 comprises one or more corresponding guiding holes 203, the method can further comprise the step of inserting each of the one or more guiding pins 103 into each of the corresponding guiding holes 203, so as to more easily insert and house each header pins group (202) into the corresponding header hole (101). To obtain the connector 2000 a cover 300 can be further applied on the PCB rear face 204, to be coupled with the housing 100.

### Reference numbers

- 100: housing
- 101: header hole
- 102: header walls
- 103: guiding pin
- 104: housing upper face
- 105: housing lower face
- 106: main body
- 107: lateral walls
- 108: first coupling means
- 109: protruding rim
- 110: floor with openings
- h1: header walls length
- 200: PCB
- 201: contact area
- 202: header pins group
- 203: guiding hole
- 204: PCB rear face
- X'Y': housing plane
- XY: PCB plane
- h2: pins length
- 300: cover
- 301: main body
- 302: lateral walls
- 303: second coupling means
- 400,500: adaptation means
- 401: elastic spring
- 501: retainer
- 502: bridge structure
- 503: wrap-around arm
- 504: protruding hook
- 1000: PCB assembly
- 2000: connector

## Claims

1. A housing (100) suitable for housing a PCB (200), said PCB (200) defining a PCB plane (XY) and comprising a plurality of connecting areas (201) provided with header pins groups (202);
said housing (100) comprising a main body (106) defining a housing plane (X'Y'), wherein said housing plane (X'Y') is parallel to said PCB plane (XY) when said PCB (200) is housed in said housing (100), said housing (100) further comprising a plurality of header holes (101) delimited by header walls (102) and configured to accommodate said corresponding header pins groups (202),
**characterized in that:**
said housing (100) further comprises adaptation means (400, 500) associated with each of said header holes (101), wherein said adaptation means (400, 500) allow the movement of each of said plurality of header walls (102) with respect to said plurality of header holes (101) in a first (X') and/or in a second (Y') direction on said housing plane (X'Y'), so as to align said header walls (102) with said header pins groups (202).

2. The housing (100) according to claim 1, wherein said adaptation means (400) comprise elastic springs (401).

3. The housing (100) according to claim 2, wherein said elastic springs (400) are mounted between each of said plurality of header holes (101) and each of said plurality of corresponding header walls (102).

4. The housing (100) according to any of the previous claims, wherein said adaptation means (500) comprise a retainer (501) configured to guide the movement of each of said header walls (102) along said first (X') and/or said second (Y') direction.

5. The housing (100) according to claim 4, wherein said retainer (501) comprises a bridge structure (502) and wrap-around arms (503);
wherein said wrap-around arms (503) surrounds completely or partially a corresponding header hole (101) of said housing (100);
and wherein said wrap-around arms (503) are steady hold together by said bridge structure (502).

6. The housing (100) according to claim 4 or 5, wherein each header wall (102), further comprise a protruding rim (109) protruding onto said main body (106) of said housing (100) and parallel to it; so that each of said header walls (102) can be suspended into said corresponding header hole (101).

7. The housing (100) according to any one of the previous claims, wherein the movement range (ΔX', ΔY') in said first (X') and/or said second (Y') direction is equal to or larger than 0,75 mm, preferably equal to or larger than 1 mm.

8. The housing (100) according to any of the previous claims, wherein said housing (100) has a rectangular shape with a short side having a length equal to or larger than 145 mm and/or a long side having a length equal to or larger than 375 mm.

9. A PCB assembly (1000) comprising:
- a housing (100) according to any one of claims 1 to 8; and
- a PCB (200) comprising a plurality of connecting areas (201) provided with header pins groups (202).

10. The PCB assembly (1000) according to claim 9, wherein said housing (100) comprises one or more guiding pins (103) associated with each header hole (101) and said PCB (200) comprises one or more corresponding guiding holes (203);
wherein each of said one or more guiding pins (103) is configured to be inserted into each of said corresponding guiding holes (203), so as to facilitate the insertion of each header pins group (202) into said corresponding header holes (101).

11. A connector (2000) comprising:
- a PCB assembly (1000) according to claim 9 or 10; and
- a cover (300),
wherein said cover (300) is suitable to be mounted onto said PCB assembly (1000) so as to protect a rear face (204) of said PCB (200) and to accommodate said PCB (200) between said housing (100) and said cover (300).

12. A method for assembling a PCB assembly (1000) comprising the following steps:
- providing a housing (100) according to any one of claims 1 to 8;
- providing a PCB (200) comprising a plurality of connecting areas (201) provided with header pins groups (202);
- coupling said housing (100) to said PCB (200), whereby said adaptation means (400, 500) move one or more of said plurality of header walls (102) with respect to said plurality of header holes (101) in said first (X') and/or said second (Y') direction, so as to align said one or more header walls (102) with the corresponding header pins group (202).

13. The method of claim 12, wherein said housing (100) comprises one or more guiding pins (103) and said PCB (200) comprises one or more corresponding guiding holes (203), and said method further comprises the following step:
- inserting one or more guiding pins (103) into the corresponding guiding hole (203).

14. The method of claim 12 or 13 further comprising the following steps:
- providing a cover (300);
- mounting said cover (300) on said housing (100).

15. Use of a PCB assembly (1000) according to any of claims 9 or 10 or of a connector (2000) according to claim 11 in a vehicle, for example a truck.
